# EUROPÄISCHE PATENTSCHRIFT

(11) **EP 2 140 746 B1**
(45) Veröffentlichungstag und Bekanntmachung des Hinweises auf die Patenterteilung: **09.11.2011**
(21) Anmeldenummer: 08736258.8
(22) Anmeldetag: 16.04.2008
(51) Int. Cl.: H05K 13/04

(54) **BESTÜCKAUTOMAT UND VERFAHREN ZUM BESTÜCKEN VON SUBSTRATEN MIT BAUELEMENTEN**
PCB ASSEMBLY MACHINE AND METHOD FOR MOUNTING COMPONENTS ONTO SUBSTRATES
AUTOMATE DE PLACEMENT DE COMPOSANTS ET PROCÉDÉ POUR PLACER DES COMPOSANTS SUR DES SUBSTRATS

(30) Priorität: 27.04.2007 DE 102007020015
(43) Veröffentlichungstag der Anmeldung: 06.01.2010
(73) Patentinhaber: ASM Assembly Systems GmbH & Co. KG, 81379 München (DE)
(72) Erfinder: SCHINDLER, Horst, 85635 Höhenkirchen-Siegertsbrunn (DE)
(74) Vertreter: Dilg, Haeusler, Schindelmann Patentanwaltsgesellschaft mbH
(86) Internationale Anmeldenummer: PCT/EP2008/054576
(87) Internationale Veröffentlichungsnummer: WO 2008/132049

(56) Entgegenhaltungen:
- EP-A- 0 942 641
- WO-A-2007/021026
- US-A- 5 203 061
- US-A1- 2005 204 553

## Beschreibung

Die Erfindung bezieht sich auf einen Bestückautomaten zum Bestücken von Substraten mit Bauelementen und ein entsprechendes Verfahren.

Beim Bestücken von Substraten, insbesondere Leiterplatten, mit Bauelementen werden Bestückautomaten eingesetzt, die einen oder mehrere Bestückköpfe mit jeweils einem oder mehreren Bauelementehaltern, beispielsweise Saugpipetten, aufweisen und mit Hilfe der Bauelementehalter Bauelemente aus Zuführeinheiten entnehmen, mittels eines XY-Positioniersystems die Bestückköpfe parallel zur Ebene des Substrats zum Substrat transportieren und dort an vorgegebenen Positionen auf den Substraten aufsetzen. Dabei werden unterschiedliche Bestückköpfe eingesetzt.

Aus EP 1 072 181 ist beispielsweise eine Bestückvorrichtung zum Bestücken von Bauelementeträgern bekannt, bei dem die Bauelementehalter sternförmig entlang des Umfangs eines Rotors angeordnet sind, welcher sich um eine zur Ebene des Substrats parallele Achse dreht, wobei an den mehreren Bauelementehaltern mehrere Bauelemente aus den Zuführeinheiten entnommen und gemeinsam zum Substrat transportiert und dort auf das Substrat aufgesetzt werden können. Weiterhin ist ein Bestückkopf beschrieben, bei dem senkrecht zur Ebene des Substrats stehende Greifer als Bauelementehalter ringförmig verteilt an einem Halter des Bestückkopfs angeordnet sind, wobei die Drehachse des Halters senkrecht zur Aufsetzfläche steht. Ein solcher Bestückkopf wird auch als Turret-Bestückkopf bezeichnet.

Aus US 2006/0112545 A1 sind ein Verfahren und eine Vorrichtung zum Bestücken von elektronischen Bauelementen bekannt, welche zwei solcher Turret-Bestückköpfe benutzen, die an einem Träger in festem Abstand zueinander angeordnet sind, wobei der Abstand so gewählt ist, dass gleichzeitig mehrere Bauelemente aus im entsprechenden Rastermaß angeordneten Zuführeinheiten entnommen werden können.

In US 5 203 061 ist ein Bestückautomat beschrieben, bei dem Bestückköpfe mit einem Bauelementehalter an einem Träger unabhängig voneinander verfahren werden können.

In EP 1 063 875 B1 ist eine Vorrichtung zur Oberflächenmontage beschrieben, welche ein X-Y-Positioniersystem aufweist und zusätzliche Antriebseinheiten für Bewegungsmittel, die unabhängige Bewegungen vom X-Y-Positioniersystem ermöglichen.

Aus EP 0 942 641 sind auch ein Verfahren und eine Vorrichtung zum Bestücken von elektromischen Bauelemente bekannt.

Es ist die Aufgabe der vorliegenden Erfindung, einen Bestückautomaten bzw. ein Verfahren zum Bestücken von Substraten mit Bauelementen anzugeben, welche eine höhere Bestückleistung aufweisen.

Die Aufgabe wird erfindungsgemäß gelöst durch einen Bestückautomaten mit den Merkmalen des Patentanspruchs 1 sowie ein Verfahren zum Bestücken von Substrat mit Bauelementen mit den Merkmalen des Patentanspruchs 7.

Der Bestückautomat weist dabei ein X-Y-Positioniersystem auf sowie mindestens zwei Bestückköpfe, die am XY-Positioniersystem so angeordnet sind, dass die mindestens zwei Bestückköpfe Bewegungen parallel zur Ebene des Substrats in einer ersten Richtung und in einer zweiten Richtung ausführen können. Darüber hinaus sind erste Antriebseinheiten für die mindestens zwei Bestückköpfe vorgesehen, welche eine voneinander unabhängige Bewegung der mindestens zwei Bestückköpfe in der ersten Richtung ermöglichen. Dabei sind mindestens zwei Bauelementehalter an jedem Bestückkopf in einer Ebene parallel zum Substrat angeordnet und jeder Bestückkopf verfügt über eine zusätzliche Antriebseinheit, die bei in der zweiten Richtung festgehaltenem XY-Positioniersystem eine Bewegung der Bauelementehalter des jeweiligen Bestückkopfs in der zweiten Richtung ermöglicht.

In anderen Worten weist der erfindungsgemäße Bestückautomat sowohl ein globales XY-Positioniersystem auf, welches beispielsweise für große Hübe ausgelegt ist, um von den Zuführeinheiten zu den Substraten zu gelangen. Darüber hinaus ist allerdings vorgesehen, dass die mindestens zwei Bestückköpfe oder zumindest die sich daran befindlichen Bauelementehalter sich derartig unabhängig voneinander bewegen können, dass die an den jeweiligen Bestückköpfen angeordneten Bauelementehalter unterschiedliche Positionen auf zu bestückenden Substraten, beispielsweise auch auf zwei unterschiedlichen Substraten erreichen. Damit lässt sich der Bestückprozess weiter parallelisieren und die Bestückleistung erhöhen.

In einer vorteilhaften Ausgestaltung des Bestückautomaten nach Patentanspruch 2 ist jedem der Bauelementhalter jeweils ein Einzeldrehantrieb eindeutig zugeordnet, so dass die Bauelementhalter unabhängig voneinander in der Ebene parallel zum Substrat drehbar sind.

Mit Hilfe der Einzeldrehantriebe können von den Bauelementhaltern (104) gehaltene Bauelemente unabhängig voneinander hinsichtlich ihrer Winkellage positioniert werden. Die Drehbewegungen der einzelnen Bauelementhalter können dabei mit den Verfahrbewegungen des XY-Positioniersystems oder des Bestückkopfs überlagert werden. Damit lässt sich der Bestückprozess weiter parallelisieren und die Bestückleistung erhöhen.

Gemäß der vorteilhaften Ausgestaltung des Bestückautomaten nach Patentanspruch 3 weist jeder Bauelementehalter eine separat ansteuerbare weitere Antriebseinheit auf zum Bewegen der Bauelementehalter in Richtung des Substrats. Durch die separat ansteuerbare weitere Antriebseinheit kann ein Bestückprozess dahingehend optimiert werden, dass die Zeitpunkte, zu denen Bauelemente auf das Substrat aufgesetzt werden für unterschiedliche Bestückköpfe voneinander unabhängig gewählte werden können.

In der vorteilhaften Ausgestaltung des Bestückautomaten nach Patentanspruch 4 weisen die mindestens zwei Bestückköpfe jeweils einen Stator und einen um eine Achse senkrecht zur Ebene des Substrats drehbaren Rotor auf, die Bauelementehalter sind am Rotor angeordnet und die zusätzliche Antriebseinheit bewirkt eine Drehung des Rotors. Durch die Drehung des Rotors bewegen sich die am Rotor angeordneten Bauelementehalter in der zweiten Richtung, womit sich bei dieser zweiten Richtung festgehaltenen XY-Positioniersystem dennoch eine Bewegung der Bauelementehalter in der zweiten Richtung erzielen lässt.

Ein weiteres Ausführungsbeispiel sieht vor, dass die mindestens zwei Bestückköpfe über jeweils einen zusätzlichen Träger am XY-Positioniersystem angeordnet sind und die zusätzliche Antriebseinheit eine Bewegung der mindestens zwei Bestückköpfe entlang des jeweiligen zusätzlichen Trägers ermöglicht. Dadurch lassen sich beispielsweise so genannte Matrix-Köpfe als Bestückköpfe einsetzen. Die Bauelementehalte an unterschiedlichen Matrix-Köpfen lassen sich dann ebenfalls unabhängig voneinander sowohl in der ersten wie auch in der zweiten Richtung bewegen selbst bei festgehaltenem XY-Positioniersystem in der zweiten Richtung.

In vorteilhafter Weise ist eine Steuereinrichtung des Bestückautomaten vorgesehen, welche eine gleichzeitige Bewegung in Richtung des Substrats von mindestens einem Bauelementehalter von jedem der mindestens zwei Bestückköpfe ermöglicht. Durch die unabhängige Bewegung in der ersten und zweiten Richtung der beiden Bestückköpfe lassen sich beliebige Positionen oberhalb von Substraten erreichen, so dass gleichzeitig zwei Bauelemente mit Hilfe zweier Bauelementehalter unterschiedlicher Bestückköpfe auf das Substrat aufgesetzt werden können, wodurch die Bestückzeiten weiter reduziert werden.

Beim erfindungsgemäßen Verfahren ist vorgesehen, dass mindestens zwei Bestückköpfe in einer ersten und in einer zweiten Richtung parallel zu einer Ebene der Substrate mit Hilfe eines XY-Positioniersystems bewegt werden, wobei mindestens einer der Bestückköpfe mindestens zwei in einer Ebene parallel zur Ebene des Substrats angeordnete Bauelementehalter aufweist, das XY-Positioniersystem in einer ersten Position in der zweiten Richtung festgehalten wird, die mindestens zwei Bestückköpfe in der ersten Richtung unabhängig voneinander bewegt werden und mindestens die Bauelementehalter jedes der mindestens zwei Bestückköpfe in der zweiten Richtung unabhängig voneinander bewegt werden. Durch die unabhängige Bewegung der Bestückköpfe bzw. Bauelementehalter selbst bei festgehaltener ersten Position in der zweiten Richtung lassen sich sowohl schnelle Bewegungen mit Hilfe des XY-Positioniersystems, beispielsweise von den Zuführeinheiten zu den Substratpositionen ermöglichen wie auch feine, kleine Bewegungen der Bestückköpfe bzw. Bauelementehalter in dieser ersten Position in der Ebene parallel zum Substrat, damit gleichzeitig Bestückpositionen erreicht werden können.

Gemäß der vorteilhaften Ausgestaltung des Verfahrens werden mindestens die Bauelementehalter gleichzeitig in Richtung des Substrats bewegt und setzen dort gleichzeitig Bauelemente ab, womit die Zeit für die Bestückung von Substraten mit Bauelementen weiter reduziert werden kann.

Die unabhängige Bewegung der mindestens je einen Bauelementehalter lässt sich dabei beispielsweise durch eine rotatorische Bewegung der jeweiligen Bestückköpfe um eine Achse senkrecht zur Ebene des Substrats bzw. durch eine translatorische Bewegung der Bestückköpfe parallel zur Ebene des Substrats ermöglichen.

In den Figuren der Zeichnung wird die Erfindung anhand eines Ausführungsbeispiels näher erläutert.

Dabei zeigen
- Fig. 1: eine schematische Draufsicht auf ein erstes Ausführungsbeispiel und
- Fig. 2: eine schematische Draufsicht auf ein zweites Ausführungsbeispiel.

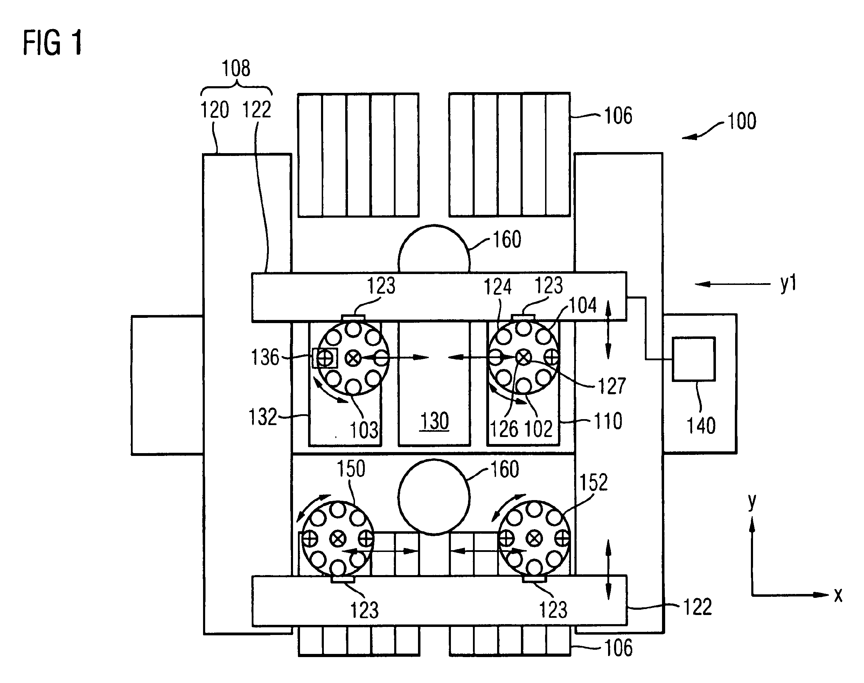

In Fig. 1 ist ein erstes Ausführungsbeispiel eines Bestückautomaten 100 dargestellt, welches mit Hilfe von Bestückköpfen 102, 103 und daran angeordneten Bauelementehaltern 104, beispielsweise Saugpipetten, Bauelemente (nicht dargestellt) aus Zuführeinheiten 106 entnimmt und mit Hilfe eines x-y-Positioniersystems 108, an dem die Bestückköpfe 102 beweglich angeordnet sind, zu Substraten 110, 130 transportiert, und dort an vorgegebenen Positionen die Bauelemente auf die Substrate 110, 130 absetzt. Das XY-Positioniersystem 108 weist dabei zwei sich in Y-Richtung erstreckende Träger 120 sowie zwei daran in Y-Richtung beweglich aufgehängte Träger 122 auf, wobei die Bestückköpfe 102 an dem jeweiligen beweglichen Träger 122 unabhängig voneinander in X-Richtung beweglich angeordnet sind und über Antriebseinheiten 123, beispielsweise Linearmotoren, separat entlang des jeweiligen beweglichen Trägers 122 angetrieben werden. Im dargestellten Beispiel sind die Bestückköpfe 102 als so genannte Turret-Bestückköpfe ausgebildet, bei denen die Bauelementehalter 104 in einer Ebene parallel zur Ebene der Substrate 110 am Umfang eines Rotors 124 angeordnet sind. Der Rotor 124 ist dabei um eine Achse 126 drehbar ausgebildet, wobei die Drehung durch eine schematisch dargestellte zusätzliche Antriebseinheit 127, beispielsweise einen Servo-Elektromotor realisiert wird.

Durch die unabhängige Bewegung der Bestückköpfe 102, 103 in X-Richtung und die Drehung des Rotors 124 um die Achse 126 lassen sich mit Hilfe der Bauelementehalter 104 beliebige Positionen oberhalb des Substrats 110 erreichen. Entsprechendes gilt für den auf der linken Seite dargestellten zweiten Bestückkopf 103 so dass die Bauelementehalter der beiden Bestückköpfe 102, 103 unabhängig voneinander selbst bei festgehaltener Y-Position Y1 des Trägers 122 beliebige Positionen oberhalb der Substrate 110, 130, 132 einnehmen können.

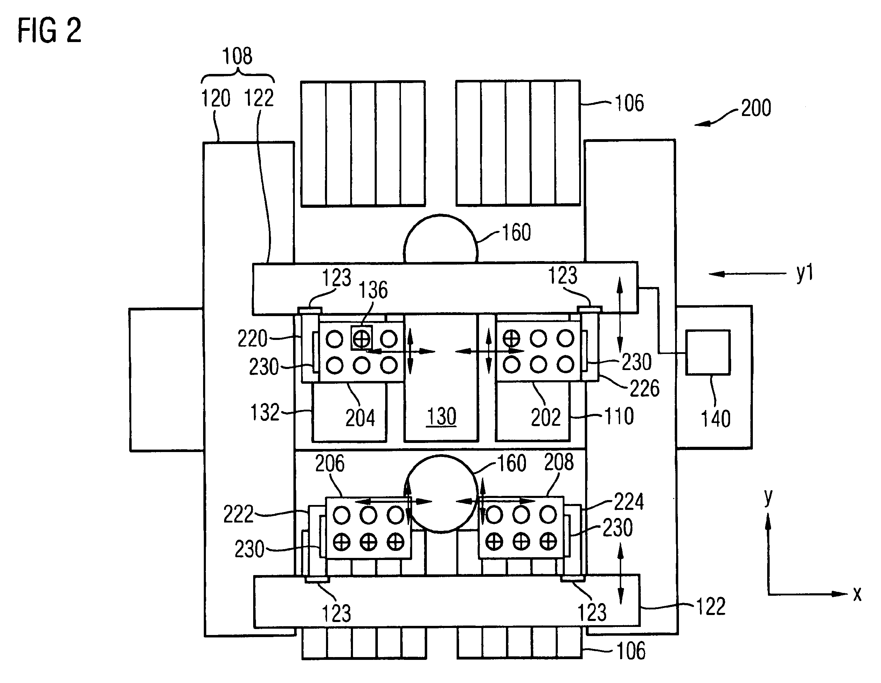

Erreichen beispielsweise die in der Fig. 1 mit einem "+" gekennzeichneten Bauelementehalter 104 die jeweiligen Positionen, auf denen die an diesen Bauelementehaltern 104 transportierten Bauelemente (nicht dargestellt) abgesetzt werden sollen, so kann beispielsweise über eine Steuereinrichtung 140 des Bestückautomaten 100 veranlasst werden, dass beide Bauelemente gleichzeitig auf den Substraten 110, 132 abgesetzt werden, wofür die einzelnen Bauelementehalter 104 jeweils eine weitere Antriebseinheit 136 aufweisen, beispielsweise einen Rotations-Hub-Motor, der beispielsweise sowohl eine Rotationsbewegung als auch eine Hubbewegung der Bauelementehalter 104 antreiben kann. Eine solche weitere Antriebseinheit 136 ist aus Gründen der Übersichtlichkeit in den Fig. 1 und 2 nur an einem der Bauelementehalter 104 dargestellt.

Durch die weiteren Antriebseinheiten 136 können die mindestens zwei Bestückköpfe 102, 103 in der festgehaltenen Position y1 auch völlig unabhängig voneinander Bauelemente auf die Substrate 110, 132 absetzen, was beispielsweise bei unterschiedlichen Bestückinhalten der Substrate 110, 132 vorteilhaft ist. Dann können beispielsweise während der Bestückung eines Bauelements auf das Substrat 110 zwei Bauelemente an nah benachbarte Positionen auf das Substrat 132 abgesetzt werden.

Beim Aufnehmen von Bauelementen aus den Zuführeinheiten 106 lassen sich bei geeignetem Rastermaß der Zuführeinheiten 106, wie anhand der beiden unteren weiteren Bestückköpfe 150 und 152 dargestellt, gleichzeitig insgesamt vier Bauelemente aus den Zuführeinheiten 106 entnehmen.

Durch die starke Parallelisierung mit Hilfe des erfindungsgemäßen Bestückautomaten lässt sich die Bestückzeit stark reduzieren und damit die Bestückleistung erhöhen.

Darüber ist im Bestückautomat 100 eine optische Kontrollstation 160 eingerichtet, um die Positionen der Bauelemente an den Bauelementehaltern 104 während des Transports von den Zuführeinheiten 106 zu den Substraten 110 zu kontrollieren.

In Fig. 2 ist ein zweites Ausführungsbeispiel eines Bestückautomaten 200 dargestellt, welches im Wesentlichen gleiche Komponenten wie das erste Ausführungsbeispiel 100 aufweist. Allerdings sind anstelle der Turret-Bestückköpfe 102, 103, 150, 152 nun Matrixköpfe 202, 204, 206 und 208 als Bestückköpfe vorgesehen. Jeder Matrixkopf 202, 204, 206, 208 weist in diesem Beispiel aus Gründen der besseren Darstellbarkeit sechs Bauelementehalter 104 auf, wobei grundsätzlich statt sechs Bauelementehaltern 104 auch größere Anzahlen an Bauelementehaltern 104 an Matrixköpfen 202, 204, 206, 208 bekannt sind. Die Matrixköpfe 202, 204, 206, 208 sind dabei jeweils an einem zusätzlichen Träger 220, 222, 224, 226 in Y-Richtung beweglich angeordnet und können sich mithilfe einer separaten zusätzlichen Antriebseinheit 230, beispielsweise ein Linearmotor, unabhängig voneinander in X- und Y-Richtung bewegen, selbst wenn das XY-Positioniersystem 108 in einer ersten Position Y1 in Y-Richtung festgehalten wird.

Durch die unabhängige Bewegung in der X- und der Y-Richtung der Matrixköpfe 202, 204, 206, 208 lassen sich ebenfalls unabhängig voneinander verschiedene Positionen oberhalb der Substrate 110 erreichen und ein gleichzeitiges Aufsetzen von Bauelementen mit Hilfe der Steuereinrichtung 140 kann erreicht werden.

Beim Aufnehmen der Bauelemente kann bei einem richtigen Rastermaß der Zuführeinheiten 106 die Anzahl der gleichzeitig aufgenommenen Bauelemente erhöht werden, indem, wie beispielsweise in Fig. 2 dargestellt, gleichzeitig sechs (die mit "+" bezeichneten) Bauelementehalter 104 Bauelemente aus den Zuführeinheiten 106 aufnehmen.

Sind, so wie in den Figuren angedeutet, drei Leiterplatten 110, 130, 132 in einem Bestückbereich, dann können die äußeren Leiterplatten 110, 132 jeweils mit den beiden auf der X-Achse getrennten Bestückköpfen 102, 103 respektive 150, 152, bzw. 202, 204 oder 206, 208 getrennt voneinander bestückt werden, während die mittlere Leiterplatte 130 von beiden Bestückköpfen erreichbar ist und somit auch von beiden Bestückköpfen bestückt werden kann.

## Patentansprüche

1. Bestückautomat (100, 200) zum Bestücken von Substraten (110, 130, 132) mit Bauelementen,
mit einem x-y-Positioniersystem (108);
mit mindestens zwei Bestückköpfen (102, 103, 150, 152, 202, 204, 206, 208), die am x-y-Positioniersystem (108) so angeordnet sind, dass die mindestens zwei Bestückköpfe (102, 103, 150, 152, 202, 204, 206, 208) Bewegungen parallel zur Ebene der Substrate (110, 130, 132) in einer ersten Richtung (x) und in einer zweiten Richtung (y) ausführen können;
mit ersten Antriebseinheiten (123) für die mindestens zwei Bestückköpfe (102, 103, 150, 152, 202, 204, 206, 208), welche eine voneinander unabhängige Bewegung der mindestens zwei Bestückköpfe (102, 103, 150, 152, 202, 204, 206, 208) in der ersten Richtung (x) ermöglichen;
mit mindestens zwei Bauelementehaltern (104) an jedem Bestückkopf (102, 103, 150, 152, 202, 204, 206, 208), die in einer Ebene parallel zum Substrat (110, 130, 132) angeordnet sind;
**dadurch gekennzeichnet, dass**
jeder Bestückkopf (102, 103, 150, 152, 202, 204, 206, 208) über eine zusätzliche Antriebseinheit (127, 230) verfügt, die bei in der zweiten Richtung (y) festgehaltenem x-y-Positioniersystem (108) eine Bewegung der Bauelementehalter (104) des jeweiligen Bestückkopfes (102, 103, 150, 152, 202, 204, 206, 208) in der zweiten Richtung (y) ermöglicht.

2. Bestückautomat (100, 200) nach Anspruch 1,
**dadurch gekennzeichnet, dass**
jedem der Bauelementhalter (104) jeweils ein Einzeldrehantrieb eindeutig zugeordnet ist, so dass die Bauelementhalter (104) unabhängig voneinander in der Ebene parallel zum Substrat (110, 130, 132) drehbar sind.

3. Bestückautomat (100, 200) nach einem der Ansprüche 1 oder 2,
**dadurch gekennzeichnet, dass**
jedem Bauelementehalter (104) eine separat ansteuerbare weitere Antriebseinheit (136) zugeordnet ist zum Bewegen der Bauelementehalter (104) in Richtung des Substrats (110, 130, 132).

4. Bestückautomat (100, 200) nach einem der Ansprüche 1 bis 3,
**dadurch gekennzeichnet, dass**
die mindestens zwei Bestückköpfe (102, 103, 150, 152, 202, 204, 206, 208) jeweils einen um eine Achse (126) senkrecht zur Ebene des Substrats (110, 130, 132) drehbaren Rotor (124) aufweisen und die Bauelementehalter (104) am Rotor (124) angeordnet sind und
dass die zusätzliche Antriebseinheit (127) eine Drehung des Rotors (124) bewirkt.

5. Bestückautomat (100, 200) nach einem der Ansprüche 1 bis 3,
**dadurch gekennzeichnet, dass**
die mindestens zwei Bestückköpfe (102, 103, 150, 152, 202, 204, 206, 208) über jeweils einen zusätzlichen Träger (220, 222, 224, 226) am x-y-Positioniersystem (108) angeordnet sind und die zusätzliche Antriebseinheit (230) eine Bewegung der mindestens zwei Bestückköpfe (102, 103, 150, 152, 202, 204, 206, 208) entlang des jeweiligen Trägers (220, 222, 224, 226) ermöglicht.

6. Bestückautomat (100, 200) nach einem der Ansprüche 1 bis 5,
**dadurch gekennzeichnet, dass**
eine Steuereinrichtung (140) vorgesehen ist, die eine gleichzeitige Bewegung in Richtung des Substrats (110, 130, 132) von mindestens einem Bauelementehalter (104) von jedem der mindestens zwei Bestückköpfe (102, 103, 150, 152, 202, 204, 206, 208) ermöglicht.

7. Verfahren zum Bestücken von Substraten (110, 130, 132) mit Bauelementen, bei dem
mindestens zwei Bestückköpfe (102, 103, 150, 152, 202, 204, 206, 208) in einer ersten Richtung (x) und in einer zweiten Richtung (y) parallel zu einer Ebene der Substrate (110, 130, 132) mit Hilfe eines x-y-Positioniersystems (108) bewegt werden, wobei mindestens einer der Bestückköpfe (102, 103, 150, 152, 202, 204, 206, 208) mindestens zwei in einer Ebene parallel zur Ebene des Substrats (110, 130, 132) angeordnete Bauelementehalter (104) aufweist,
das x-y-Positioniersystem (108) in einer ersten Position (y1) in der zweiten Richtung (y) festgehalten wird,
die mindestens zwei Bestückköpfe (102, 103, 150, 152, 202, 204, 206, 208) in der ersten Richtung (x) unabhängig voneinander bewegt werden,
mindestens je ein Bauelementehalter (104) jedes der mindestens zwei Bestückköpfe (102, 103, 150, 152, 202, 204, 206, 208) in der zweiten Richtung (y) unabhängig voneinander bewegt werden.

8. Verfahren nach Anspruch 7,
**dadurch gekennzeichnet, dass**
die mindestens je einen Bauelementehalter (104) gleichzeitig in Richtung des Substrats (110, 130, 132) bewegt werden und dort gleichzeitig Bauelemente absetzen.

9. Verfahren nach Anspruch 7,
**dadurch gekennzeichnet, dass**
die mindestens je einen Bauelementehalter (104) unabhängig voneinander in Richtung des Substrats (110, 130, 132) bewegt werden und dort Bauelemente absetzen.

10. Verfahren nach einem der Ansprüche 7 bis 9,
**dadurch gekennzeichnet, dass**
die Bewegung der mindestens je einen Bauelementehalter (104) durch eine rotatorische Bewegung der jeweiligen Bestückköpfe (102, 103, 150, 152) um eine Achse (126) senkrecht zur Ebene des Substrats (110, 130, 132) erfolgt.

11. Verfahren nach einem der Ansprüche 7 bis 9,
**dadurch gekennzeichnet, dass**
die Bewegung der mindestens je einen Bauelementehalter (104) durch eine translatorische Bewegung der Bestückköpfe (202, 204, 206, 208) parallel zur Ebene des Substrats (110, 130, 132) erfolgt.

## Claims

1. An assembling machine (100, 200) for assembling of substrates (110, 130, 132) with components,
having a x-y positioning system (108),
having at least two assembling heads (102, 103, 150, 152, 202, 204, 206, 208), which are arranged in such a way at the x-y positioning system (108) that the at least two assembling heads (102, 103, 150, 152, 202, 204, 206, 208) are able to carry out movements parallel to the plane of the substrates (110, 130, 132) in a first direction (x) and in a second direction (y);
having first actuating units (123) for the at least two assembling heads (102, 103, 150, 152, 202, 204, 206, 208), which permit a movement of the at least two assembling heads (102, 103, 150, 152, 202, 204, 206, 208) independent from each other in the first direction (x);
having at least two component holder (104) at each assembling head (102, 103, 150, 152, 202, 204, 206, 208), which are arranged in a plane parallel to the substrate (110, 130, 132);
**characterized in that**
each assembling head (102, 103, 150, 152, 202, 204, 206, 208) possesses an additional actuating unit (127, 230) which permits a movement of the component holder (104) of the respective assembling head (102, 103, 150, 152, 202, 204, 206, 208) in the second direction (y) in case that the x-y positioning system (108) is retained in the second direction (y).

2. The assembling machine (100, 200) according to claim 1,
**characterized in that**
a single rotary drive is each unambiguously assigned to each of the component holder (104) so that the component holders (104) are independently rotatable from each other in the plane parallel to the substrate (110, 130, 132).

3. The assembling machine (100, 200) according to the claims 1 or 2,
**characterized in that**
a separately controllable further actuating unit (136) is assigned to each component holder (104) for moving of the component holder (104) in direction of the substrate (110, 130, 132).

4. The assembling machine (100, 200) according to one of the claims 1 to 3,
**characterized in that**
the at least two assembling heads (102, 103, 150, 152, 202, 204, 206, 208) each comprise a rotor (124) rotatable around an axis (126) perpendicular to the plane of the substrate (110, 130, 132) and the component holder (104) are arranged at the rotor (124) and
that the additional actuating unit (127) causes a rotation of the rotor (124).

5. The assembling machine (100, 200) according to one of the claims 1 to 3,
**characterized in that**
the at least two assembling heads (102, 103, 150, 152, 202, 204, 206, 208) are arranged at the x-y positioning system (108) via a respective additional carrier (220, 222, 224, 226) and the additional actuating unit (230) permits a movement of the at least two assembling heads (102, 103, 150, 152, 202, 204, 206, 208) along the respective carrier (220, 222, 224, 226).

6. The assembling machine (100, 200) according to one of the claims 1 to 5,
**characterized in that**
a control device (140) is provided, which permits a simultaneous movement in direction of the substrate (110, 130, 132) of at least one component holder (104) of each of the at least two assembling heads (102, 103, 150, 152, 202, 204, 206, 208).

7. A method for assembling of substrates (110, 130, 132) with components, in which
at least two assembling heads (102, 103, 150, 152, 202, 204, 206, 208) are moved in a first direction (x) and in a second direction (y) parallel to a plane of the substrates (110, 130, 132) with aid of a x-y positioning system (108), wherein at least one of the assembling heads (102, 103, 150, 152, 202, 204, 206, 208) comprises at least two component holders (104) arranged in a plane parallel to the plane of the substrate (110, 130, 132),
the x-y positioning system (108) is retained in a first position (y1) in the second direction (y),
the at least two assembling heads (102, 103, 150, 152, 202, 204, 206, 208) are independently moved from each other in the first direction,
at least respectively one component holder (104) of each of the at least two assembling heads (102, 103, 150, 152, 202, 204, 206, 208) are independently moved from each other in the second direction (y).

8. The method according to claim 7,
**characterized in that**
the at least respectively one component holders (104) are simultaneously moved in direction of the substrate (110, 130, 132) and components are simultaneously set down there.

9. The method according to claim 7,
**characterized in that**
the at least respectively one component holders (104) are independently moved from each other in direction of the substrate (110, 130, 132) and components are set down there.

10. The method according to one of the claims 7 to 9,
**characterized in that**
the movement of the at least respectively one component holder (104) is carried out by a rotary movement of the respective assembling heads (102, 103, 150, 152) around an axis (126) perpendicular to the plane of the substrate (110, 130, 132).

11. The method according to one of the claims 7 to 9,
**characterized in that**
the movement of the at least respectively one components holder (104) is carried out by a translatory movement of the assembling heads (202, 204, 206, 208) parallel to the plane of the substrate (110, 130, 132).

## Revendications

1. Automate de placement (100, 200) pour placer des composants sur des substrats (110, 130, 132), comprenant
un système de positionnement xy (108) ;
au moins deux têtes de placement (102, 103, 150, 152, 202, 204, 206, 208) qui sont disposées sur le système de positionnement xy (108) de telle sorte que lesdites au moins deux têtes de placement (102, 103, 150, 202, 204, 206, 208) peuvent effectuer des mouvements en parallèle au plan des substrats (110, 130, 132) dans une première direction (x) et dans une deuxième direction (y) ;
des premières unités d'entraînement (123) pour lesdites au moins deux têtes de placement (102, 103, 150, 152, 202, 204, 206, 208) qui permettent un mouvement indépendant les unes des autres desdites au moins deux têtes de placement (102, 103, 150, 152, 202, 204, 206, 208) dans la première direction (x) ;
au moins deux supports de composant (104) sur chaque tête de placement (102, 103, 150, 152, 202, 204, 206, 208) qui sont disposés dans un plan parallèle au substrat (110, 130, 132) ;
**caractérisé en ce que**
chaque tête de placement (102, 103, 150, 152, 202, 204, 206, 208) dispose d'une unité d'entraînement supplémentaire (127, 230) qui permet un mouvement des supports de composant (104) de la tête de placement (102, 103, 150, 152, 202, 204, 206, 208) respective dans la deuxième direction (y) lorsque le système de positionnement xy (108) est retenu.

2. Automate de placement (100, 200) selon la revendication 1, **caractérisé en ce que** chacun des supports de composant (104) se voit attribuer de façon univoque respectivement un dispositif d'entraînement rotatif individuel de sorte que les supports de composant (104) peuvent tourner indépendamment les uns des autres dans le plan parallèle au substrat (110, 130, 132).

3. Automate de placement (100, 200) selon l'une quelconque des revendications 1 ou 2, **caractérisé en ce que** chaque support de composant (104) se voit attribuer une unité d'entraînement (136) supplémentaire, pouvant être commandée séparément, pour déplacer les supports de composant (104) en direction du substrat (110, 130, 132).

4. Automate de placement (100, 200) selon l'une quelconque des revendications 1 à 3, **caractérisé en ce que** lesdites au moins deux têtes de placement (102, 103, 150, 152, 202, 204, 206, 208) présentent respectivement un rotor (124) pouvant tourner autour d'un axe (126) perpendiculaire au plan du substrat (110, 130, 132), et les supports de composant (104) sont disposés sur le rotor (124), et **en ce que** l'unité d'entraînement (127) supplémentaire provoque une rotation du rotor (124).

5. Automate de placement (100, 200) selon l'une quelconque des revendications 1 à 3, **caractérisé en ce que** lesdites au moins deux têtes de placement (102, 103, 150, 152, 202, 204, 206, 208) sont disposées respectivement par l'intermédiaire d'un support (220, 222, 224, 226) supplémentaire sur le système de positionnement xy (108), et l'unité d'entraînement (230) supplémentaire permet un mouvement desdites au moins deux têtes de placement (102, 103, 150, 152, 202, 204, 206, 208) le long du support (220, 222, 224, 226) respectif.

6. Automate de placement (100, 200) selon l'une quelconque des revendications 1 à 5, **caractérisé en ce qu'**un équipement de commande (140) est prévu qui permet un mouvement simultané en direction du substrat (110, 130, 132) d'au moins un support de composant (104) de chacun desdites au moins deux têtes de placement (102, 103, 150, 152, 202, 204, 206, 208).

7. Procédé de placement de composants sur des substrats (110, 130, 132), dans lequel
au moins deux têtes de placement (102, 103, 150, 152, 202, 204, 206, 208) sont déplacées dans une première direction (x) et dans une deuxième direction (y) en parallèle à un plan des substrats (110, 130, 132) à l'aide d'un système de positionnement xy (108), dans lequel au moins l'une des têtes de placement (102, 103, 150, 152, 202, 204, 206, 208) présente au moins deux supports de composant (104) disposés dans un plan parallèle au plan du substrat (110, 130, 132),
le système de positionnement xy (108) est retenu dans une première position (y1) dans la deuxième direction (y),
lesdites au moins deux têtes de placement (102, 103, 150, 152, 202, 204, 206, 208) sont déplacées dans la première direction (x) indépendamment les unes des autres,
au moins respectivement un support de composant (104) de chacune desdites au moins deux têtes de placement (102, 103, 150, 152, 202, 204, 206, 208) est déplacé dans la deuxième direction (y) indépendamment les uns des autres.

8. Procédé selon la revendication 7, **caractérisé en ce que** ledit au moins respectivement un support de composant (104) est déplacé en même temps en direction du substrat (110, 130, 132) et y dépose des composants en même temps.

9. Procédé selon la revendication 7, **caractérisé en ce que** ledit au moins respectivement un support de composant (104) est déplacé indépendamment les uns des autres en direction du substrat (110, 130, 132) et y dépose des composants.

10. Procédé selon l'une quelconque des revendications 7 à 9, **caractérisé en ce que** le mouvement dudit au moins respectivement un support de composant (104) est effectué par un mouvement rotatif des têtes de placement (102, 103, 150, 152, 202, 204, 206, 208) respectives autour d'un axe (126) perpendiculaire au plan du substrat (110, 130, 132).

11. Procédé selon l'une quelconque des revendications 7 à 9, **caractérisé en ce que** le mouvement dudit au moins respectivement un support de composant (104) s'effectue par un mouvement de translation des têtes de placement (102, 103, 150, 152, 202, 204, 206, 208) en parallèle au plan du substrat (110, 130, 132).
